# FASCICULE DE BREVET EUROPEEN

(11) **EP 1 419 533 B1**
(45) Date de publication et mention de la délivrance du brevet: **13.12.2006**
(21) Numéro de dépôt: 02780920.1
(22) Date de dépôt: 28.06.2002
(51) Int. Cl.: H01L 27/12, G09G 3/36, H01L 27/146

(54) **MATRICE ACTIVE DE TRANSISTORS EN COUCHES MINCES OU TFT POUR CAPTEUR OPTIQUE OU ECRAN DE VISUALISATION**
AKTIVE MATRIX VON DÜNNFILMTRANSISTOREN (TFT) FÜR EINEN OPTISCHEN SENSOR ODER EINEN ANZEIGESCHIRM
ACTIVE MATRIX OF THIN-FILM TRANSISTORS (TFT) FOR AN OPTICAL SENSOR OR DISPLAY SCREEN

(30) Priorité: 29.06.2001 FR 0108625
(43) Date de publication de la demande: 19.05.2004
(73) Titulaire: Thomson, 92100 Boulogne-Billancourt (FR); Thomson Licensing, 92100 Boulogne-Billancourt (FR)
(72) Inventeur: LEBRUN, Hugues, Thales Intellectual Property, F-94117 Arcueil Cedex (FR)
(74) Mandataire: Ruellan-Lemonnier, Brigitte
(86) Numéro de dépôt international: PCT/FR2002/002258
(87) Numéro de publication internationale: WO 2003/003463

(56) Documents cités:
- FR-A- 2 737 314
- FR-A- 2 772 499
- US-B1- 6 191 830
- BOER DEN W ET AL: "SIMILARITIES BETWEEN TFT ARRAYS FOR DIRECT-CONVERSION X-RAY SENSORSAND HIGH-APERTURE AMLCDS" 1998 SID INTERNATIONAL SYMPOSIUM DIGEST OF TECHNICAL PAPERS. ANAHEIM, CA, MAY 17 - 22, 1998, SID INTERNATIONAL SYMPOSIUM DIGEST OF TECHNICAL PAPERS, SANTA ANA, CA: SID, US, vol. 29, 1998, pages 371-374, XP000965457 ISSN: 0098-966X

## Description

La présente invention concerne une matrice active de transistors en couches minces ou TFT (pour Thin Film Transistor) pour capteurs optiques ou écrans de visualisation.

L'utilisation d'une matrice active de transistors en couches minces est bien connue dans le domaine des écrans de visualisation à cristaux liquides ou des capteurs optiques pour rayons X. De manière typique, une telle matrice comporte un substrat, une matrice de transistors TFT formée sur ce substrat, chaque transistor comportant une grille, une première électrode ou drain et une seconde électrode ou source, un ensemble de lignes pour commander les transistors TFT par la grille, cet ensemble de lignes étant placé sur le substrat, un niveau conducteur selon un motif déterminé formant une matrice d'électrodes de pixel, les électrodes de pixel étant reliées à l'une des électrodes des transistors, un ensemble de colonnes permettant un transfert de charges à travers les transistors entre les électrodes de pixel et une électronique de commande, les colonnes étant reliées à l'autre électrode des transistors et une couche isolante entre les électrodes de pixel et les colonnes, cette couche isolante étant ouverte localement sur chaque pixel pour mettre en contact les électrodes de pixel et l'autre électrode du transistor.

Lorsqu'une matrice active de ce type doit être utilisée dans un capteur optique, elle comporte une couche semi-conductrice photosensible en contact avec les électrodes de pixel pour convertir le rayonnement électromagnétique en charges recueillies par les électrodes. Dans ce cas, le rayonnement électromagnétique qui frappe la couche semi-conductrice photosensible est converti en charges électriques qui sont recueillies par les électrodes de pixel. Ces charges électriques sont analysées dans un circuit électronique pour restituer une image point par point, par exemple à l'aide d'afficheurs à cristaux liquides. Une utilisation particulière d'une matrice de TFTs du type ci-dessus concerne la réalisation d'images à partir de rayons X lorsque la couche semi-conductrice est avantageusement formée par du sélénium.

Selon une autre application, une matrice active de transistors en couches minces du type décrit ci-dessus peut être utilisée dans un écran de visualisation de type réflectif ou transfléctif. Dans ce cas, les électrodes de pixel sont réalisées en un matériau réfléchissant tel que l'aluminium et une couche de cristal liquide recouvre les électrodes de pixel en étant associée avec un substrat transparent.

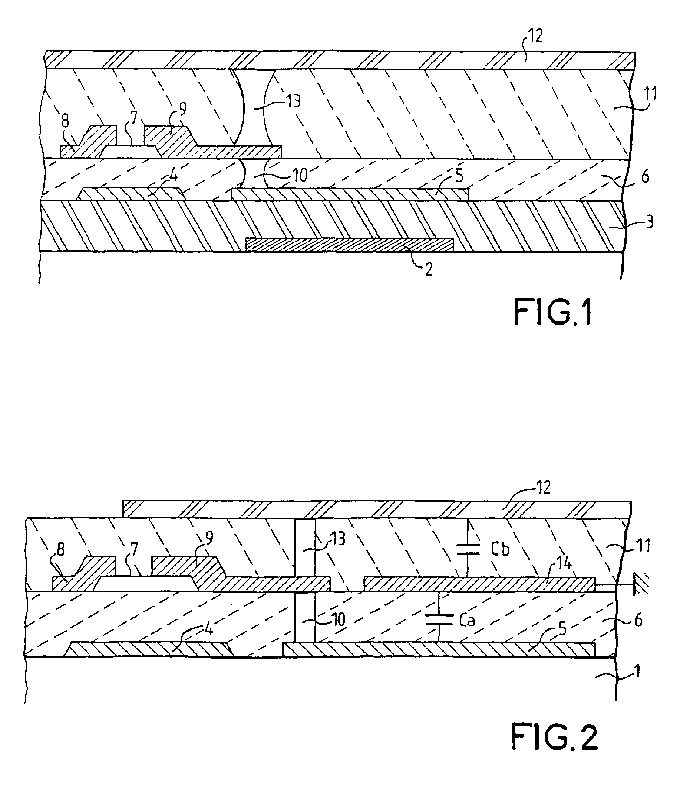

Si l'on se rapporte plus particulièrement au cas d'un capteur optique, utilisé en imagerie à rayons X, pour améliorer le contraste des images obtenues, il est utile d'avoir sur les électrodes de pixel une forte capacité pour stocker des charges élevées. En effet, plus les charges stockées sont élevées, meilleur est le contraste d'images. Actuellement et comme représenté sur la figure 1, une forte capacité de stockage est obtenue en réalisant un plan de masse enterré et une électrode capacitive au niveau de la grille. De manière plus précise, sur un substrat 1 est déposée une couche d'un métal tel que du titane dont le but est de former un plan de masse 2. Cette couche de titane est gravée de manière à obtenir l'électrode capacitive 2. Ensuite, sur cette électrode capacitive 2 est déposée de manière connue une couche d'isolant 3 réalisée en un matériau tel que de l'oxyde de silicium SiO2 sur une épaisseur de, par exemple, 2000, A. On dépose alors sur la couche isolante une bi-couche métallique de titane et de molybdène qui est ensuite gravée de manière à réaliser la grille 4 du transistor en couches minces ainsi qu'une seconde électrode 5 qui forme une capacité de stockage avec l'électrode 2. De manière connue, on dépose ensuite une couche isolante 6 en nitrure de silicium SiN présentant, par exemple, une épaisseur de 3000 Å puis une couche 7 de matériau semiconducteur 7 tel que du silicium amorphe, par exemple. Cette couche 7 est gravée de manière connue. On dépose ensuite une couche métallique en molybdène par exemple, que l'on grave de manière à réaliser la première électrode 8 ou drain et la seconde électrode 9 ou source des transistors en couches minces. De manière connue, l'électrode de source 9 est connectée en 10 à l'électrode capacitive 5. Une fois les source et drain 8, 9 réalisés, on dépose une couche 11 en un matériau isolant tel que du nitrure de silicium SiN sur une épaisseur plus importante, par exemple d'environ 5000 Å. On réalise alors un trou de connexion 13 au niveau de la source 9 dont le rôle sera expliqué ci-après. Puis, de manière connue, on dépose sur la couche isolante SiN une couche métallique transparente telle qu'une couche d'ITO (pour Oxyde d'Indium et de Titane), de manière à réaliser l'électrode de pixel 12. Cette électrode de pixel est connectée via le trou 13 à la source 9 pour fonctionner de manière connue. Dans ce cas, la capacité de stockage est obtenue entre l'électrode 5 et l'électrode 2 formant plan de masse. Toutefois, pour réaliser cette capacité de stockage, il est nécessaire d'avoir deux niveaux de masquage supplémentaires par rapport à un procédé de réalisation de matrice active standard. De plus, l'isolant de la capacité, à savoir la couche isolante 3, doit être mince de façon à garantir une valeur de capacité de stockage la plus forte possible.

Le document US-Bl-6 191 830 décrit une matrice active de transistors en couches minces.

La présente invention a donc pour but de proposer une nouvelle structure de matrice active de transistors en couches minces ou TFT pour capteur optique ou écran de visualisation qui ne nécessite pas les deux niveaux de masquage décrits ci-dessus.

En conséquence, la présente invention a pour objet une matrice active de transistors en couches minces ou TFT (Thin Film Transistor) pour capteurs optiques ou écrans de visualisation du type comportant :
- un substrat,
- une matrice de transistors TFT formée sur ce substrat, chaque transistor comportant une grille, une première électrode ou drain et une seconde électrode ou source,
- un ensemble d'électrodes de ligne pour commander les transistors TFT par leur grille, cet ensemble de lignes étant placé sur le substrat,
- un niveau conducteur selon un motif déterminé formant une matrice d'électrodes de pixel, les électrodes de pixel étant reliées à l'une des électrodes des transistors,
- un ensemble de colonnes permettant un transfert de charges à travers les transistors entre les électrodes de pixel et une électronique de commande, les colonnes étant reliées à l'autre électrode des transistors,
- une couche isolante entre les électrodes de pixel et les colonnes, cette couche isolante étant ouverte localement sur chaque pixel pour mettre en contact l'électrode de pixel et l'autre électrode du transistor,
caractérisée en ce qu'elle comporte un ensemble d'électrodes capacitives situées au même niveau que les électrodes des transistors de manière à former avec les électrodes de pixel des capacités de stockage.

Ainsi, selon l'invention, on utilise pour réaliser la capacité de stockage le même matériau métallique que celui utilisé pour réaliser la première électrode ou drain et la seconde électrode ou source des transistors TFT, l'électrode capacitive étant réalisée au même niveau que ces deux électrodes. De ce fait, la capacité de stockage est formée entre le matériau métallique de l'électrode de pixel et un plan de masse réalisé dans le même métal que les deux électrodes drain-source des transistors.

Selon une autre caractéristique de la présente invention, les électrodes capacitives sont reliées de manière à former des lignes de stockage parallèles aux colonnes, l'ensemble des lignes de stockage étant connecté à un même potentiel.

Selon une autre caractéristique de la présente invention, la matrice active comporte des connexions formant pont pour relier les lignes de stockage de manière à réaliser un plan de masse.

Selon encore une autre caractéristique de la présente invention, elle comporte de plus des lignes de stockage supplémentaires situées au même niveau que les grilles des transistors et parallèlement aux colonnes, ces lignes de stockage supplémentaires formant des capacités de stockage avec les électrodes capacitives.

Selon un mode de réalisation préférentiel, les lignes de stockage supplémentaires sont réalisées dans le même matériau que les grilles des transistors. D'autre part, selon l'utilisation de la matrice active de transistors en couches minces ou TFT, la matrice active sera recouverte d'une couche semi-conductrice photosensible en contact avec les électrodes de pixel pour convertir le rayonnement électromagnétique en charges électriques recueillies par les électrodes dans le cas des capteurs optiques ou la matrice active sera recouverte d'une couche de cristal liquide puis d'un substrat transparent en verre, dans le cas d'un écran de visualisation réflectif.

D'autres caractéristiques et avantages de la présente invention apparaîtront à la lecture de la description d'un mode de réalisation préférentiel, faite avec référence aux dessins ci-annexés dans lesquels,
- la figure 1 déjà décrite est une vue en coupe verticale schématique d'un pixel associé à un transistor TFT dans une matrice active selon l'art antérieur,
- la figure 2 est une vue en coupe verticale schématique d'un pixel associé à un transistor TFT selon un mode de réalisation de la présente invention,
- la figure 3 est une vue en plan schématique du niveau métallique des première et seconde électrodes ou drain-source du transistor TFT associé à des électrodes capacitives conformément à la présente invention, et
- la figure 4 est une vue en plan schématique d'une matrice active de transistor TFT conforme à la présente invention, utilisée dans un capteur optique.

Pour simplifier la description dans les figures, les mêmes éléments portent les mêmes références.

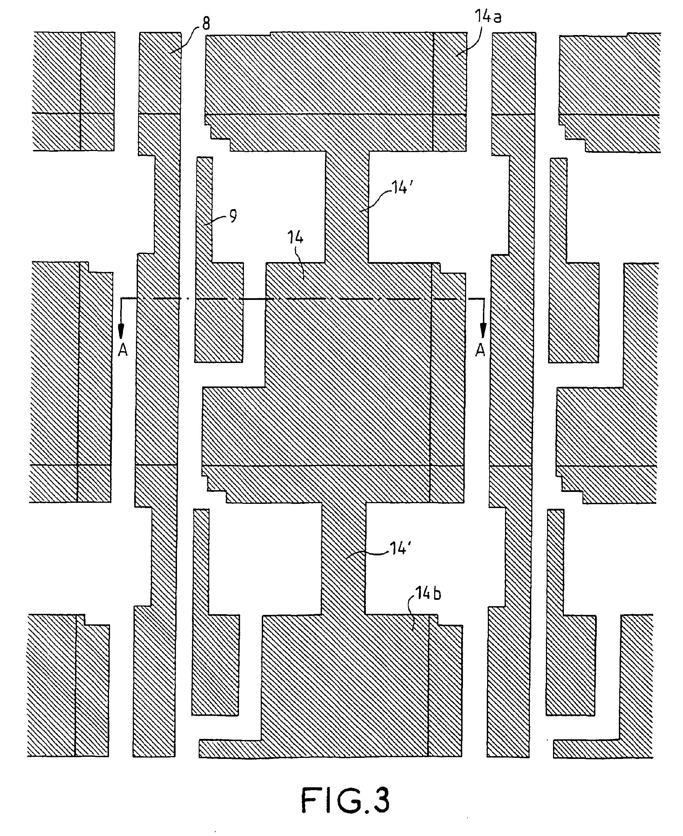

On décrira maintenant avec référence aux figures 2 à 4, un exemple de réalisation d'une matrice active à transistors en couches minces conforme à la présente invention. Pour simplifier la description, dans ce mode de réalisation, les éléments identiques à ceux de la figure 1 sont référencés avec les mêmes chiffres, notamment en ce qui concerne le transistor et l'électrode de pixel. D'autre part, la figure 2 correspond à une coupe selon A-A dans la figure 3.

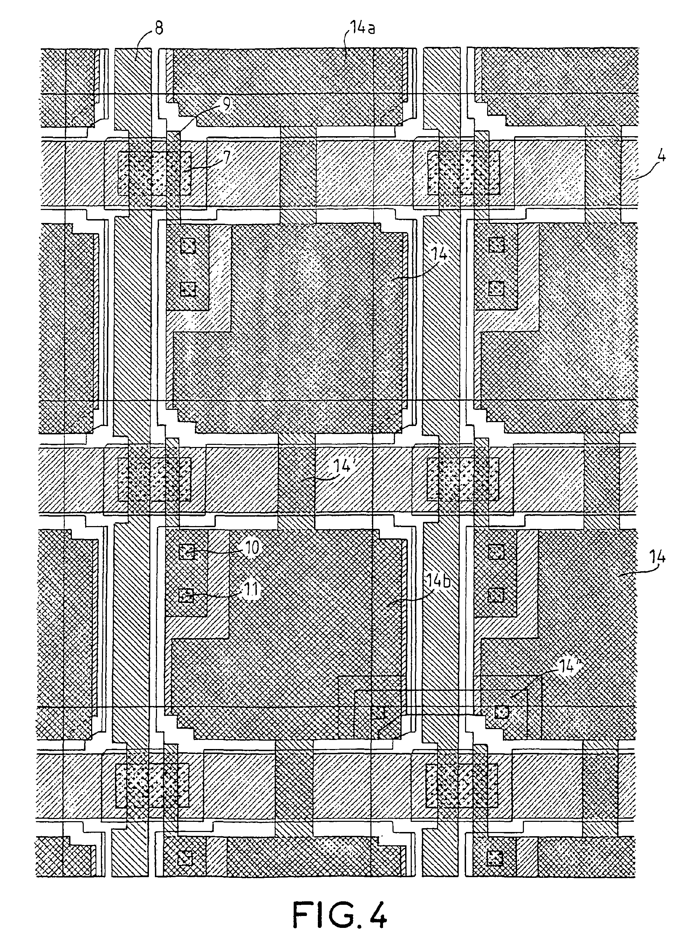

Comme représenté dans la figure 2, sur un substrat 1 on a déposé une couche métallique, par exemple une bi-couche titane-molybdène qui a été gravée pour réaliser l'électrode 4 des transistors en couches minces, ainsi qu'une électrode capacitive 5 dont le rôle sera expliqué ci-après. Sur cette couche métallique, a été déposée une couche isolante 6 d'épaisseur relativement faible, par exemple de 3000 Å. Cette couche isolante est, dans le mode de réalisation représenté, une couche de nitrure de silicium SiN. De manière connue, des trous de connexion 10 ont été réalisés au-dessus des électrodes capacitives 5. Le rôle de ces trous de connexion sera expliqué ci-après. Ensuite, pour réaliser les transistors en couches minces, on dépose sur la couche isolante 6 en SiN, une couche conductrice, par exemple en silicium amorphe. Cette couche conductrice est gravée, de manière connue, pour réaliser la couche conductrice 7 des transistors en couches minces. Ensuite, on dépose une couche métallique, par exemple une couche de molybdène qui est gravée de manière à former une première électrode ou drain 8 et une seconde électrode ou source 9 pour les transistors en couches minces au-dessus de la couche 7. Conformément à la présente invention et comme représenté de manière plus précise sur les figures 3 et 4, la couche métallique en molybdène est aussi gravée de manière à réaliser des électrodes capacitives 14.

Comme représenté sur la figure 3, ces électrodes capacitives 14, dont le rôle sera expliqué ci-après, sont reliées les unes aux autres par des bandes conductrices en molybdène 14' de manière à former des colonnes d'électrodes capacitives telles que 14a, 14b. Ensuite, de manière connue, on dépose une couche d'un matériau isolant 11 qui peut présenter par exemple une épaisseur de 5000 Å. Cette couche de matériau isolant est réalisée, à titre d'exemple, en nitrure de silicium ou SiN. Dans cette couche isolante 11, on réalise de manière connue des trous de connexion 13 au niveau des électrodes 9 ou source. Puis, on dépose sur la couche isolante, une couche en un matériau conducteur qui peut être soit un matériau conducteur transparent tel que de l'ITO pour « Oxyde d'Indium et d'Etain » ou du SNO pour « Oxyde d'Etain », soit un matériau réflectif tel que l'aluminium. Cette couche métallique 12 est gravée de manière à réaliser les électrodes de pixel. Ensuite, suivant l'utilisation qui sera faite de la matrice active, on peut déposer une couche semi-conductrice transparente telle que du sélénium pour capter les rayons X ou une couche de cristal liquide pour réaliser un écran de visualisation.

Selon une variante de réalisation telle que représentée sur la figure 4, les colonnes d'électrodes capacitives 14a, 14, 14b peuvent être connectées les unes avec les autres par l'intermédiaire d'un pont 14" en un matériau conducteur tel que du molybdène, passant au-dessus de l'électrode ou drain formant colonne 8. De ce fait, l'ensemble des électrodes capacitives est relié à un même potentiel et forment un plan de masse enterré qui facilite l'écoulement des charges. Conformément à la présente invention, on peut utiliser un seul pont entre deux colonnes d'électrodes capacitives, comme représenté sur la figure 4, ou plusieurs ponts, notamment un pont par électrode capacitive ou un pont toutes les N électrodes capacitives.

Si l'on compare les procédés de réalisation d'une matrice active à transistors en couches minces selon l'art antérieur telle que représentée à la figure 1 ou conformément à la présente invention telle que représentée sur la figure 2, on s'aperçoit que le fait de réaliser les électrodes capacitives au même niveau que les première et seconde électrodes ou source et drain des transistors permet d'éliminer deux étapes de photolithographie. D'autre part, les électrodes de pixel 12 et les électrodes capacitives 5 se trouvant au même niveau que les grilles sont à un même potentiel puisqu'elles sont connectées à l'électrode source 9 par les connexions 13 et 10, comme représenté sur la figure 2. De ce fait, on obtient deux capacités Ca et Cb en parallèle, ce qui permet d'obtenir une capacité de stockage importante permettant d'avoir un meilleur contraste des images obtenues.

## Revendications

1. Matrice active de transistors en couches minces ou TFT (Thin Film Transistor) pour capteur optique ou écran de visualisation, du type comportant :
- un substrat (1),
- une matrice de transistors TFT formée sur ce substrat, chaque transistor comportant une grille (4), une première électrode ou drain (8) et une seconde électrode ou source (9),
- un ensemble d'électrodes de ligne pour commander les transistors TFT par leur grille, cet ensemble de lignes étant placé sur le substrat,
- un niveau conducteur selon un motif déterminé formant une matrice d'électrodes de pixel, les électrodes de pixel étant reliées à l'une des électrodes des transistors,
- un ensemble de colonnes permettant un transfert de charges à travers les transistors entre les électrodes de pixel et une électronique de commande, les colonnes étant reliées à l'autre électrode des transistors,
- une couche isolante entre les électrodes de pixel et les colonnes, cette couche isolante étant ouverte localement sur chaque pixel pour mettre en contact l'électrode de pixel et l'autre électrode du transistor,
**caractérisée en ce qu'**elle comporte un ensemble d'électrodes capacitives (14) situées au même niveau que les électrodes des transistors de manière à former avec les électrodes de pixel des capacités de stockage.

2. Matrice selon la revendication 1, **caractérisée en ce que** les électrodes capacitives (14) sont réalisées dans le même matériau que les électrodes source et drain des transistors.

3. Matrice selon les revendications 1 ou 2, **caractérisée en ce que** les électrodes capacitives sont reliées de manière à former des lignes de stockage parallèles aux colonnes.

4. Matrice selon la revendication 3, **caractérisée en ce que** l'ensemble des lignes de stockage est relié à un même potentiel.

5. Matrice selon les revendications 3 et 4, **caractérisée en ce qu'**elle comprend des connexions (14") formant pont pour relier les lignes de stockage de manière à réaliser un plan de masse.

6. Matrice selon l'une quelconque des revendications 1 à 5, **caractérisée en ce qu'**elle comporte de plus des lignes de stockage (5) supplémentaires situées au même niveau que les grilles (4) des transistors et parallèlement aux colonnes, ces lignes de stockage supplémentaires formant des capacités de stockage avec les électrodes capacitives.

7. Matrice selon la revendication 6, **caractérisée en ce que** les lignes de stockage (5) supplémentaires sont réalisées dans le même matériau que les grilles (4) des transistors.

8. Matrice selon l'une quelconque des revendications précédentes, **caractérisée en ce qu'**elle est recouverte d'une couche semi-conductrice photosensible en contact avec les électrodes de pixel pour convertir le rayonnement électromagnétique en charges électriques recueillies par les électrodes.

9. Capteur optique, en particulier pour rayons X, **caractérisé en ce qu'**il comporte une matrice active selon l'une des revendications 1 à 8.

10. Matrice selon l'une quelconque des revendications 1 à 8, **caractérisée en ce qu'**elle est recouverte d'une couche de cristaux liquides, d'une contre-électrode et d'un substrat transparent.

11. Ecran de visualisation de type réflectif ou transfléctif, **caractérisé en ce qu'**il comporte une matrice active selon les revendications 1 à 8 et 10.

## Claims

1. An active matrix of thin-film transistors or TFTs for an optical sensor or display screen, of the type comprising:
- a substrate (1) ;
- a matrix of TFT transistors formed on this substrate, each transistor comprising a gate (4), a first electrode or drain (8) and a second electrode or source (9) ;
- a set of row electrodes for controlling the TFT transistors via their gates, this set of rows being placed on the substrate ;
- a conducting level in a defined pattern forming a matrix of pixel electrodes, the pixel electrodes being connected to one of the electrodes of the transistors ;
- a set of columns for transferring charges through the transistors between the pixel electrodes and drive electronics, the columns being connected to the other electrode of the transistors ; and
- an insulating layer between the pixel electrodes and the columns, this insulating layer being open locally to each pixel in order to bring the pixel electrode into contact with the other electrode of the transistor ;
**characterized in that** it includes a set of capacitive electrodes (14) lying at the same level as the electrodes of the transistors so as to form, with the pixel electrodes, storage capacitors.

2. Matrix according to claim 1, **characterized in that** the capacitive electrodes (14) are produced in the same material as the source and drain electrodes of the transistors.

3. Matrix according to claim 1 or 2, **characterized in that** the capacitive electrodes are connected so as to form storage lines parallel to the columns.

4. Matrix according to claim 3, **characterized in that** the set of storage lines is connected to a same potential.

5. Matrix according to claims 3 and 4, **characterized in that** it includes connections (14") forming a bridge for connecting the storage lines so as to produce a ground plane.

6. Matrix according to any one of claims 1 to 5, **characterized in that** it also comprises additional storage lines (5) lying at the same level as the gates (4) of the transistors and parallel to the columns, these additional storage lines forming, with the capacitive electrodes, storage capacitors.

7. Matrix according to claim 6, **characterized in that** the additional storage lines (5) are produced in the same material as the gates (4) of the transistors.

8. Matrix according to any one of the preceding claims, **characterized in that** it is covered with a photosensitive semiconductor layer in contact with the pixel electrodes in order to convert the electromagnetic radiation into electrical charges picked up by the electrodes.

9. An optical sensor, in particular for X-rays, **characterized in that** it comprises an active matrix according to one of claims 1 to 8.

10. Matrix according to any one of claims 1 to 8, **characterized in that** it is covered with a layer of liquid crystals, with a back electrode and with a transparent substrate.

11. A display screen of the reflective or transflective type, **characterized in that** it comprises an active matrix according to claims 1 to 8 and 10.

## Patentansprüche

1. Aktive Matrix von Dünnfilmtransistoren oder TFT (TFT: Thin Film Transistor) für einen optischen Sensor oder einen Anzeigeschirm mit
- einem Substrat (1);
- einer auf diesem Substrat gebildeten Matrix von TFT-Transistoren, wobei jeder Transistor ein Gate (4), eine erste Elektrode bzw. Drain (8) und eine zweite Elektrode bzw. Source (9) aufweist,
- einer Menge von Zeilenelektroden für die Steuerung der TFT-Transistoren über deren Gate, wobei diese Zeilenmenge auf dem Substrat angeordnet ist,
- einer Ebene, die gemäß einem bestimmten, eine Matrix von Pixelelektroden bildenden Muster leitend ist, wobei die Pixelelektroden mit einer der Elektroden der Transistoren verbunden sind,
- einer Menge von Spalten, die einen Transfer von Ladungen durch die Transistoren zwischen den Pixelelektroden und einer Steuerungselektronik ermöglicht, wobei die Spalten mit der anderen Elektrode der Transistoren verbunden sind,
- einer Isolierschicht zwischen den Pixelelektroden und den Spalten, wobei diese Isolierschicht lokal bei jedem Pixel geöffnet ist, um die Pixelelektrode und die andere Elektrode des Transistors in Kontakt zu bringen,
**dadurch gekennzeichnet, dass** sie eine Menge von kapazitiven Elektroden (14) aufweist, die sich auf derselben Ebene wie die Elektroden der Transistoren befinden, so dass sie mit den Pixelelektroden Speicherkapazitäten bilden.

2. Matrix nach Anspruch 1, **dadurch gekennzeichnet, dass** die kapazitiven Elektroden (14) aus demselben Material wie die Source- und Drainelektroden der Transistoren hergestellt sind.

3. Matrix nach Ansprüchen 1 oder 2, **dadurch gekennzeichnet, dass** die kapazitiven Elektroden derart verbunden sind, dass sie parallel zu den Spalten verlaufende Speicherzeilen bilden.

4. Matrix nach Anspruch 3, **dadurch gekennzeichnet, dass** die Menge der Speicherzeilen mit einem gleichen Potential verbunden ist.

5. Matrix nach Ansprüchen 3 und 4, **dadurch gekennzeichnet, dass** sie Verbindungen (14") umfasst, die eine Brücke bilden, um die Speicherzeilen derart zu verbinden, dass eine Masseebene ausgebildet wird.

6. Matrix nach einem der Ansprüche 1 bis 5, **dadurch gekennzeichnet, dass** sie ferner zusätzliche Speicherzeilen (5) aufweist, die auf derselben Ebene wie die Gates (4) der Transistoren und parallel zu den Spalten angeordnet sind, wobei diese zusätzlichen Speicherzeilen mit den kapazitiven Elektroden Speicherkapazitäten bilden.

7. Matrix nach Anspruch 6, **dadurch gekennzeichnet, dass** die zusätzlichen Speicherzeilen (5) aus demselben Material wie die Gates (4) der Transistoren hergestellt sind.

8. Matrix nach einem der vorhergehenden Ansprüche, **dadurch gekennzeichnet, dass** sie mit einer photoempfindlichen Halbleiterschicht überzogen ist, die mit den Pixelelektroden in Kontakt ist, um die elektromagnetische Strahlung in elektrische Ladungen umzuwandeln, die von den Elektroden gesammelt werden.

9. Optischer Sensor, insbesondere für Röntgen-Strahlen, **dadurch gekennzeichnet, dass** er eine aktive Matrix nach einem der Ansprüche 1 bis 8 aufweist.

10. Matrix nach einem der Ansprüche 1 bis 8, **dadurch gekennzeichnet, dass** sie mit einer Flüssigkristallschicht, einer Gegenelektrode und einem durchsichtigen Substrat überzogen ist.

11. Anzeigeschirm von der reflektiven oder der transmissiv-reflektiven Bauart, **dadurch gekennzeichnet, dass** er eine aktive Matrix nach den Ansprüchen 1 bis 8 und 10 aufweist.
